# FASCICULE DE BREVET EUROPEEN

(11) **EP 0 391 790 B1**
(45) Date de publication et mention de la délivrance du brevet: **04.09.1996**
(21) Numéro de dépôt: 90400909.9
(22) Date de dépôt: 03.04.1990
(51) Int. Cl.: H01L 23/24, H01L 23/498, H01L 21/48

(54) **Procédé de fabrication d'un module électronique**
Herstellungsverfähren für elektronische Module
Method of manufacturing an electronic module

(30) Priorité: 07.04.1989 FR 8904581
(43) Date de publication de la demande: 10.10.1990
(73) Titulaire: SGS-THOMSON MICROELECTRONICS S.A., F-94250 Gentilly (FR)
(72) Inventeur: Steffen, Francis, F-75116 Paris (FR)
(74) Mandataire: Schmit, Christian Norbert Marie

(56) Documents cités:
- EP-A- 0 128 822
- EP-A- 0 197 438
- EP-A- 0 231 937
- PATENT ABSTRACTS OF JAPAN, vol. 7, no. 7 (E-216)[1425], 14 décembre 1983; & JP-A-58 158 953

## Description

L'invention concerne l'encapsulation de puces de circuits intégrés, notamment en vue de leur incorporation sur un support portable.

La technique habituelle pour encapsuler des circuits intégrés destinés à être incorporés par exemple sur une carte à puces est la suivante :
- la puce est reportée soit sur une grille de conducteurs métalliques soit sur un support diélectrique du type verre epoxy tramé portant des conducteurs imprimés photogravés; ces conducteurs comprennent d'une part une plage de contact sur laquelle on vient souder la face arrière de la puce, et d'autre part des plages de contact sur lesquelles on vient souder des fils d'or ou d'aluminium par exemple qui sont par ailleurs soudés sur les plots de sortie de la puce; ces conducteurs constituent par ailleurs des bornes de connexion extérieures du circuit-intégré après encapsulation; les plages de contact peuvent être aussi soudées directement sur la puce (technique dite "TAB");
- on recouvre partiellement ou totalement la puce et ses fils d'une protection contre les agressions mécaniques et chimiques; celle-ci peut être une résine époxy ou une résine aux silicones;
- on découpe en micromodules individuels la bande portant les puces protégées par la résine;
- on colle le micromodule dans une cavité superficielle ménagée dans un support portable en matière plastique, de telle sorte que les conducteurs de connexion restent accessibles en surface.

Le support en matière plastique peut être réalisée par moulage par injection (la matière est alors par exemple de la résine ABS); il peut aussi être réalisé par usinage; il peut être réalisé par laminage de feuilles de matière plastique prédécoupées (les découpes servant notamment à réaliser la cavité pour loger le micromodule); dans ce cas, la matière plastique peut être du chlorure de polyvinyle.

On rencontre plusieurs problèmes dans ces techniques d'assemblage du module sur son support d'encartage; un premier problème est le risque que la résine de protection de la puce coule entre les conducteurs lors de sa mise en place; le débordement est gênant pour les opérations d'assemblage du module sur son support; un deuxième problème, dans le cas d'une carte, est l'obligation d'assembler par collage le micromodule, la fiabilité de ce mode de fixation n'étant pas idéale compte-tenu de la différence entre les matériaux constituant la carte et ceux constituant le micromodule; un troisième problème est la reproductibilité des dimensions extérieures du micromodule qui doit s'ajuster dans une cavité de dimensions données (de préférence très peu profonde) dans la carte à puce.

L'invention a pour but l'amélioration de la fiabilité du montage, la reproductibilité des dimensions du micromodule, et la réduction de sa hauteur, tout en conservant un procédé de fabrication facile à mettre en oeuvre.

On connait de la demande de brevet européen EP-A-197438 un procédé qui consiste à fabriquer d'une part une grille métallique avec une pluralité d'ouvertures dans lesquelles pénétrent des languettes destinées à former des plages de contacts et d'autre part des pastilles en matière plastique que l'on place sur les languettes de chaque ouverture, à coller une puce de circuit intégré au fond de l'évidement de chaque pastille et à relier les bornes de connexion de la puce aux languettes.

On connait aussi un micromodule avec une forme définie par un fin blindage métallique en forme d'anneau collé sur les plages de contacts du micromodule (demande de brevet EP-A-0231937).

On propose selon l'invention un procédé d'encapsulation d'un circuit-intégré qui consiste pour l'essentiel à partir d'un substrat mixte de matière plastique et de métal formé par report (collage ou transfert à chaud) d'un écran diélectrique préperforé sur une grille métallique prédécoupée. Dans un exemple, cet écran diélectrique est une bande de matière plastique. Dans un autre exemple cet écran est une préforme moulée, découpée, ou usinée.

Telle que revendiquée, l'invention concerne un procédé de fabrication d'un micromodule comprenant les étapes de :
- découpe d'une grille conductrice métallique pour définir les futures bornes de connexion électrique, la grille étant en forme d'une bande pour réaliser plusieurs des micromodules en série sur cette bande ;
- perforation d'un écran diélectrique ;
- report de l'écran sur la grille ;
- mise en place d'une puce de circuit-intégré dans une perforation de l'écran, et formation de connexions électriques entre la puce et des zones de la grille situées dans d'autres perforations de l'écran.

Selon l'invention, l'écran est en forme d'une bande pour réaliser plusieurs des micromodules en série sur cette bande.

De préférence, les découpes de la grille et les perforations de la bande sont telles que la grille bouche intégralement toutes les perforations de la bande, au moins dans la zone utile des contacts du module encapsulé ainsi réalisé.

Par "transfert à chaud" de l'écran diélectrique sur la grille, on entend une opération par laquelle l'écran diélectrique est déroulé en bande et est appliqué contre la grille à une température où la bande est ramollie; la bande adhère à la grille lors du refroidissement. Dans ce cas, on prévoit de préférence que la grille comporte des aspérités et découpes favorisant l'accrochage. Ces aspérités sont par exemple des bavures de découpage non éliminées, des ergots saillants sur la grille, des trous, etc.

La bande de matière plastique peut être constituée par un ruban plat. Dans ce cas, on prévoit de préférence qu'avant mise en place d'une matière de protection ou même qu'avant la mise en place de la puce, la zone comprenant la puce et ses connexions est entourée d'un anneau de protection, dont la hauteur est aussi faible que possible mais suffisante pour dépasser la hauteur de la puce et des connexions (surtout si ces connexions sont des fils soudés). Cet anneau sert à constituer une cavité dans laquelle on versera la matière de protection. Ce peut être un anneau métallique.

La bande de matière plastique peut aussi être constituée par un ruban plat comportant de place en place des excroissances en forme d'anneau : au lieu que l'anneau soit rapporté ultérieurement sur la bande, il est formé en même temps qu'elle, par exemple par moulage ou usinage.

La matière de protection peut être une résine thermoplastique (type polyuréthane) ou thermodurcissable (type silicone). Elle est en principe isolante mais elle peut être de préférence un diélectrique imparfait à perte (pour aboutir à une résistance de l'ordre de 10 à 10000 Mégohms). Ceci permet l'écoulement des charges électrostatiques par les fils de connexion.

Lorsque la résine de protection est mise en place, elle ne fuit pas par les interstices de la grille découpée car on a de préférence pris la précaution que ces interstices soient tous bouchés, au moins dans les parties utiles, par la bande de matière plastique.

On réalise ainsi un micromodule qui comprend d'une part une matière isolante (plastique) qui est la bande perforée rapportée par collage ou par transfert à chaud sur la grille de conducteurs découpée, et d'autre part de préférence une matière de protection (résine) pour compléter la protection de la puce contre les agressions chimiques et mécaniques. Les perforations de la bande recouvrent des plages conductrices de la grille découpée sans recouvrir des interstices entre ces plages; une puce de circuit-intégré est placée dans une perforation de la bande et connectée électriquement à des plages conductrices situées dans d'autres perforations de la bande.

Pour l'incorporation à une carte, on prévoit de préférence que la matière de l'écran plastique reporté. est compatible avec la matière plastique de la carte (chlorure de polyvinyle par exemple), et on peut ainsi placer le micromodule directement dans une cavité formée dans la carte, la bande de matière plastique du micromodule étant directement en contact avec la matière plastique de la carte; le montage est fait par collage ou soudure par ultrasons par exemple, ce qui était difficilement possible dans l'art antérieur avec des matériaux peu compatibles sur la carte et sur le micromodule.

D'autres caractéristiques et avantages de l'invention apparaîtront à la lecture de la description détaillée qui suit et qui est faite en référence aux dessins annexés dans lesquels :
- la figure 1 représente en vue de dessus et en coupe une grille métallique découpée utilisée dans l'invention;
- la figure 2 représente en vue de dessus et en coupe une bande d'écrans diélectriques préperforés utilisés selon l'invention;
- la figure 3 représente en coupe la bande reportée par collage ou transfert à chaud sur la grille;
- la figure 4 représente une puce de circuit-intégré mise en place et connectée à la grille;
- la figure 5 représente la mise en place d'un anneau et d'une résine de protection, l'anneau peut même de préférence être mis en place avant la puce ;
- la figure 6 représente une variante de réalisation dans laquelle l'anneau de protection est intégré à la bande et non rapporté sur elle.

Le procédé selon l'invention va maintenant être détaillé en référence aux figures. On part d'une grille métallique prédécoupée 10 définissant les futures bornes de connexion électrique du micromodule qu'on cherche à fabriquer. En pratique on réalise non pas une grille isolée pour un micromodule unique mais une grille en bande continue; les micromodules seront réalisés en série sur cette bande; ils ne seront séparés les uns des autres qu'à la fin du processus de fabrication, voire même, dans le cas de micromodules destinés à des cartes à puces, seulement au moment de l'encartage.

La grille métallique est formée par découpage mécanique (estampage). Elle a une épaisseur de quelques dixièmes de millimètres environ. Elle est donc relativement résistante. Elle peut être en fer-nickel, ou cuivre par exemple, ou encore en nickel pur; elle peut être recouverte d'or ou d'argent sur la face arrière, et sur la face avant à l'endroit où seront soudées des connexions avec une puce.

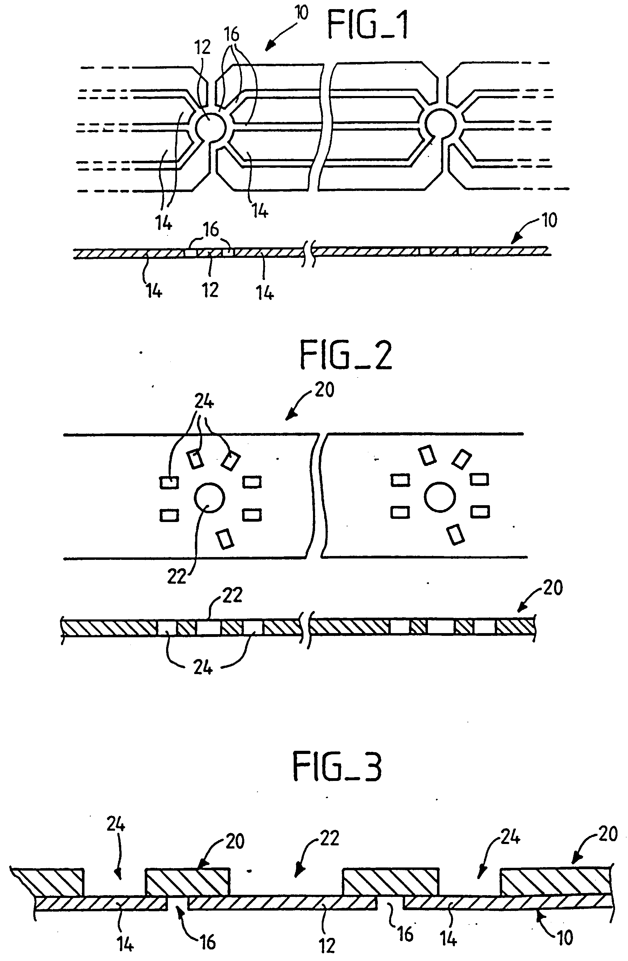

La grille comporte en principe une plage centrale conductrice 12 pour recevoir une puce de circuit-intégré, et des plages conductrices périphériques 14 entourant cette plage centrale. Les plages sont séparées les unes des autres par des interstices 16 formées par l'opération de découpage. Ces interstices sont visibles sur la vue de dessus et la coupe de la figure 1.

On réalise par ailleurs une bande d'écrans diélectriques en matière plastique perforée 20, en forme de ruban essentiellement plan (figure 2). Des perforations sont faites, par exemple par matriçage dans cette bande, à des endroits judicieusement choisis. Ces perforations comprennent en principe un trou central 22 (pour loger une puce de circuit-intégré) et des trous. périphériques 24 (pour l'accès aux bornes de connexion).

Les positions du trou central 22 et de la plage centrale 12 se correspondent de telle manière que lorsque la bande plastique est reportée sur la grille métallique le trou central 22 vient au dessus de la plage centrale 12, de préférence sans venir au dessus d'un interstice 16 de la grille découpée. Le trou central 22 est donc plus petit que la plage 12 et sera placé à l'intérieur de cette plage.

De même, les positions des trous périphériques et des plages conductrices périphériques se correspondent de telle manière que lorsque la bande 20 est reportée sur la grille 10, chaque trou périphérique 24 arrive en regard d'une extrémité d'une plage conductrice respective 14. Là encore, de préférence, les trous ne recouvrent pas d'interstices 16 entre plages conductrices.

A partir de la grille prédécoupée et de la bande préperforée, on réalise une opération de report de la bande sur la grille en respectant les positions relatives indiquées ci-dessus. La bande plastique bouchera donc en principe tous les interstices entre plages conductrices de la grille.

Le report peut se faire par simple collage : on déroule la bande plastique perforée et le ruban de grille découpée simultanément, en interposant une fine couche de colle entre les deux et en pressant la bande contre la grille. Le report peut se faire aussi par transfert à chaud en réalisant un simple pressage de la bande contre la grille, à une température où la matière constituant la bande est ramollie (par exemple à 150 à 200 degrés celsius selon la matière plastique utilisée). Ce pressage à chaud permet un accrochage efficace de la bande sur la grille lors du refroidissement.

L'accrochage est favorisé si la surface de la grille présente des aspérités (bavures de découpes, pliages d'ergots en saillie perpendiculairement à la surface du ruban de grille, ou en oblique, etc.).

La figure 3 représente la grille et la bande superposées, en coupe à une échelle agrandie (mais arbitraire : les épaisseurs relatives des couches et les largeurs représentées ne sont pas significatives).

On peut vérifier sur la figure 3 qu'on s'est arrangé pour placer le trou central 22 au dessus de la plage centrale 12, sans déborder de cette plage. Et les trous 24 sont placés au dessus d'extrémités de plages conductrices 14, sans déborder au dessus d'interstices 16.

Les interstices de la grille sont donc tous bouchés, en tous cas dans la région utile du micromodule.

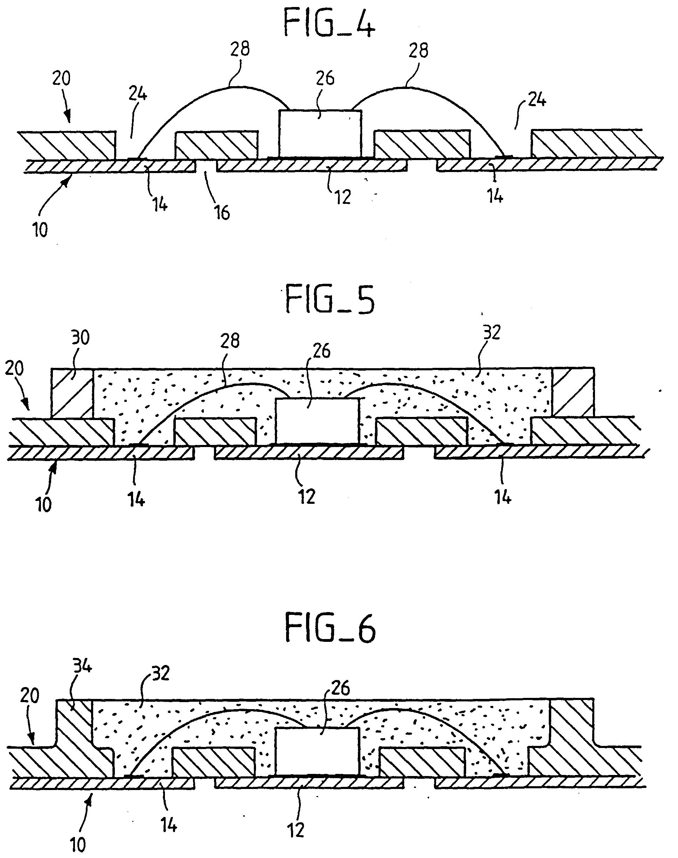

On met ensuite en place une puce 26 sur le ruban mixte métal/plastique ainsi constitué (figure 4).

Dans l'exemple représenté, la puce 26 est collée ou soudée par sa face arrière sur la plage centrale conductrice 12, à l'intérieur du trou 22; elle est reliée aux plages conductrices périphériques 14 par des fils de liaison 28 (fils d'or ou d'aluminium par exemple). Ces fils sont soudés d'une part sur des plots de la puce et d'autre part sur les plages conductrices 14 à l'intérieur des trous 24 de la bande 20 de plastique.

Les surfaces de la grille métallique découpée du côté arrière, c'est-à-dire du côté non recouvert par la bande 20, seront les surfaces de contact d'accès au circuit-intégré à partir de l'extérieur, notamment dans le cas où le micromodule sera incorporé à une carte à puce.

On place autour de la puce 26 et des fils de liaison 28 un anneau de protection 30 (figure 5). Cet anneau est de préférence métallique (mais il pourrait être en matière plastique); il peut être collé ou reporté à chaud sur la bande plastique 20. Dans ce cas l'anneau est reporté de préférence avant la mise en place de la puce. L'anneau entoure les perforations centrale et périphériques formées dans la bande 20 et correspondant à un micromodule déterminé. On peut imaginer qu'un micromodule comprenne plusieurs puces reliées ou non entre elles, auquel cas l'anneau entoure toutes les puces et les fils de liaison correspondant à ce micromodule. La hauteur de l'anneau est choisie, compte-tenu de l'épaisseur de la bande 20, pour que le bord supérieur de l'anneau dépasse en hauteur la puce et les fils.

L'anneau et le ruban mixte plastique/métal définissent alors une cavité de protection de la puce et des fils. On remplit cette cavité avec une matière de protection 32 (par exemple une résine thermoplastique telle que du polyuréthane ou une résine thermodurcissable telle qu'une résine aux silicones). La matière de protection enrobe complètement la puce et les fils. Son volume est défini latéralement par l'anneau de protection. En hauteur, la matière remplit de préférence complètement l'anneau. Si elle dépasse de l'anneau lors du remplissage, il est possible de l'araser ensuite.

Etant donné qu'on a fait en sorte que toutes les perforations de la bande plastique 20 soient bouchées au fond par des portions de grille conductrice 10, la résine ne fuit pas, même si elle est très fluide, par les interstices 16 entre les plages conductrices de la grille.

A la figure 6, on a représenté une variante de réalisation qui se distingue de la précédente en ce que l'anneau de protection n'est pas un anneau rapporté sur la bande 20 mais il est une partie intégrante, moulée ou usinée, de la bande 20. Cette partie 34 vient en saillie de place en place (à l'endroit de chaque micromodule) sur le ruban plan constituant la bande 20.

La face arrière de la grille est dénudée totalement, c'est-à-dire non recouverte de matière isolante. La face arrière de la grille restera accessible directement pour un contact électrique entre les conducteurs et des contacts d'un lecteur de cartes à puces.

On a ainsi réalisé un ruban mixte métal/plastique portant de place en place des puces protégées par un anneau et une matière isolante de protection. On constitue donc un rouleau de micromodules en bande. La bande ne sera découpée en micromodules individuels qu'en fin de fabrication des micromodules, ou même seulement au moment de l'encartage.

La précision obtenue sur les dimensions du micromodule est très bonne et reproductible d'un micromodule à un autre; on ne sera donc pas gêné comme dans le passé par des problèmes d'imprécision des dimensions de la goutte de résine de protection, en hauteur comme en largeur.

La hauteur de l'anneau 30 peut être réduite au strict minimum puisqu'elle est très bien contrôlée; il est important pour une carte à puce que le micromodule ait une hauteur aussi réduite que possible, mais pour cela il faut un procédé très fiable de fabrication, et c'est ce que permet la présente invention.

## Revendications

1. Procédé de fabrication d'un micromodule comprenant les étapes de :
- découpe d'une grille conductrice métallique (10) pour définir les futures bornes de connexion électrique, la grille étant en forme d'une bande pour réaliser plusieurs des micromodules en série sur cette bande ;
- perforation d'un écran diélectrique (20) ;
- report de l'écran sur la grille ;
- mise en place d'une puce de circuit-intégré (26) dans une perforation (22) de l'écran, et formation de connexions électriques entre la puce et des zones (14) de la grille situées dans d'autres perforations (24) de l'écran ;
ledit procédé étant caractérisé en ce que l'écran est en forme d'une bande pour réaliser plusieurs des micromodules en série sur cette bande.

2. Procédé selon la revendication 1, caractérisé en ce que les perforations (22, 24) de l'écran et les découpes de la grille sont telles que l'écran recouvre et bouche tous les interstices (16) entre conducteurs de la grille dans la région utile correspondant à un module à réaliser.

3. Procédé selon l'une des revendications 1 et 2, caractérisé en ce qu'il comprend une étape de mise en place d'une protection par une matière de protection (32) recouvrant la puce et les connexions dans les perforations (22, 24) de la bande de matière plastique (20).

4. Procédé selon l'une quelconque des revendications 1 à 3, caractérisé en ce qu'il comprend la mise en place sur l'écran d'un anneau de protection (30) entourant la puce (26) et ses connexions (28), cet anneau étant rempli de matière isolante de protection (32) après sa mise en place.

5. Procédé selon l'une quelconque des revendications 1 à 3, caractérisé en ce que l'écran comprend de place en place une excroissance (34) en forme d'anneau entourant l'espace réservé à la puce et à ses connexions, et en ce que cet anneau est rempli d'une matière de protection (32) après mise en place de la puce et de ses connexions.

6. Procédé selon l'une des revendications 3 à 5, caractérisé en ce que la matière de protection est une résine thermoplastique ou thermodurcissable.

7. Procédé selon l'une des revendications 3 à 6, caractérisé en ce que la matière de protection est un diélectrique imparfait pour permettre l'écoulement des charges électrostatiques.

8. Procédé selon l'une des revendications 1 à 7, caractérisé en ce que l'écran (20) est reporté sur la grille (10) par collage ou transfert à chaud.

9. Procédé selon l'une des revendications 1 à 8, caractérisé en ce qu'il comprend une étape supplémentaire de séparation des micromodules pour obtenir des micromodules individuels.

10. Procédé selon la revendication 9, caractérisé en ce qu'il comprend une étape d'encapsulation d'au moins un des micromodules individuels dans un support portable.

## Patentansprüche

1. Verfahren zur Herstellung eines Mikromoduls, umfassend die Schritte:
- Schneiden eines leitfähigen Gatebereichs aus Metall (10), um zukünftige elektrische Anschlußklemmen festzulegen, wobei der Gatebereich in Form eines Bandes ausgebildet wird, um eine Mehrzahl von Mikromodulen in Reihe auf diesem Band zu erzeugen;
- Perforieren einer dieelektrischen Abschirmung (20);
- Übertragen der Abschirmung auf den Gatebereich;
- Anordnen eines integrierten Schaltungschips (26) in einer Perforation (22) der Abschirmung und Ausbilden elektrischer Verbindungen zwischen dem Chip und sich in anderen Perforationen (24) der Abschirmung befindenden Zonen (14) des Gatebereichs;
dadurch gekennzeichnet, daß die Abschirmung in Form eines Bandes ausgebildet ist, um eine Mehrzahl von Mikromodulen in Reihe auf diesem Band zu erzeugen.

2. Verfahren nach Anspruch 1, dadurch gekennzeichnet, daß die Perforationen (22, 24) der Abschirmung und die Schnitte des Gatebereichs derart ausgebildet sind, daß die Abschirmung sämtliche Zwischenräume (16) zwischen Leitern des Gatebereichs in dem einem herzustellenden Modul entsprechenden Nutzbereich überdeckt und ausfüllt.

3. Verfahren nach einem der Ansprüche 1 und 2, gekennzeichnet durch einen Schritt des Anbringens eines Schutzes durch ein Schutzmaterial (32), welches den Chip und die Verbindungen in den Perforationen (22, 24) des Bandes aus Plastikmaterial (20) überdeckt.

4. Verfahren nach einem der Ansprüche 1 bis 3, dadurch gekennzeichnet, daß es das Anordnen eines den Chip (26) und seine Verbindungen (28) ringförmig einschließenden Schutzrings (30) auf der Abschirmung umfaßt, wobei der Ring nach seiner Anbringung mit isolierendem Schutzmaterial (32) gefüllt wird.

5. Verfahren nach einem der Ansprüche 1 bis 3, dadurch gekennzeichnet, daß die Abschirmung stellenweise eine Ausstülpung (34) in Form eines den für den Chip und seine Verbindungen reservierten Raum umschließenden Rings umfaßt, und daß dieser Ring nach dem Anbringen des Chips und seiner Verbindungen mit einem Schutzmaterial (32) gefüllt wird.

6. Verfahren nach einem der Ansprüche 3 bis 5, dadurch gekennzeichnet, daß daß das Schutzmaterial ein thermoplastisches oder warmaushärtendes Harz ist.

7. Verfahren nach einem der Ansprüche 3 bis 6, dadurch gekennzeichnet, daß das Schutzmaterial ein nicht verlustloses Dielektrikum ist zum Zulassen der Ableitung elektrostatischer Ladungen.

8. Verfahren nach einem der Ansprüche 1 bis 7, dadurch gekennzeichnet, daß die Abschirmung (20) durch Kleben oder Wärmeübertragung auf den Gatebereich übertragen wird.

9. Verfahren nach einem der Ansprüche 1 bis 8, gekennzeichnet durch einen zusätzlichen Schritt des Trennens der Mikromodule zum Erzeugen einzelner Mikromodule.

10. Verfahren nach Anspruch 9, gekennzeichnet durch einen Schritt der Kapselung zumindest eines der einzelnen Mikromodule in einen portablen Träger.

## Claims

1. Method of manufacturing a micromodule, comprising the steps of:
- cutting out a metal conductive grille (10) to define the future electrical connection terminals, the grille being in the form of a strip, to produce several of the micromodules in series on this strip;
- perforating a dielectric screen (20);
- transferring the screen onto the grille;
- positioning an integrated circuit chip (26) in a perforation (22) in the screen, and forming electrical connections between the chip and areas (14) of the grille situated in other perforations (24) in the screen;
the said method being characterised in that the screen is in the form of a strip, to produce several of the micromodules in series on this strip.

2. Method according to Claim 1, characterised in that the perforations (22, 24) in the screen and the cutouts in the grille are such that the screen covers and closes off all the interstices (16) between conductors of the grille in the useful region corresponding to a module to be produced.

3. Method according to one of Claims 1 and 2, characterised in that it comprises a step of positioning a protector formed by a protective material (32) covering the chip and the connections in the perforations (22, 24) in the strip of plastic (20).

4. Method according to any one of Claims 1 to 3, characterised in that it comprises the positioning on the screen of a protective ring (30) surrounding the chip (26) and its connections (28), this ring being filled with a protective insulating material (32) after it has been positioned.

5. Method according to any one of Claims 1 to 3, characterised in that the screen comprises, at various places, a ring-shaped protuberance (34) surrounding the space reserved for the chip and its connections, and in that this ring is filled with a protective material (32) after the chip and its connections have been positioned.

6. Method according to one of Claims 3 to 5, characterised in that the protective material is a thermoplastic or thermosetting resin.

7. Method according to one of Claims 3 to 6, characterised in that the protective material is an imperfect dielectric in order to allow electrostatic charges to flow.

8. Method according to one of Claims 1 to 7, characterised in that the screen (20) is transferred onto the grille (10) by means of bonding or hot transfer.

9. Method according to one of Claims 1 to 8, characterised in that it comprises an additional step of separating the micromodules in order to obtain individual micromodules.

10. Method according to Claim 9, characterised in that it comprises a step of encapsulating at least one of the individual micromodules in a portable substrate.
